# EUROPEAN PATENT APPLICATION

(11) **EP 4 794 202 A2**
(43) Date of publication of application: **19.08.2026**
(21) Application number: 26183055.8
(22) Date of filing: 04.06.2026
(51) Int. Cl.: H03M 1/14, H03M 1/12, H03M 1/36, H03M 1/46, H03M 1/80

(54) **AN ANALOGUE TO DIGITAL CONVERTER**

(71) Applicant: NXP B.V., 5656 AG Eindhoven (NL); University Of Twente, 7522 NB Enschede (NL)
(72) Inventor: Cents, Remon Bernardus Antonius, 5656AG Eindhoven (NL); Bindra, Harijot Singh, 5656AG Eindhoven (NL)
(74) Representative: Colaiuda, Antonella

(57) **Abstract**

Herein is disclosed a voltage input terminal configured to receive an input voltage; flash analogue to digital converter, ADC; an ADC, wherein the ADC comprises: a plurality of capacitors configured and arranged such that they at least partially define the bit resolution of the ADC; a controller; wherein: the flash ADC is configured to receive the input voltage and provide a flash ADC signal, wherein the flash ADC signal is a digital representation of the input voltage; the controller is configured to provide for pre-charging of the plurality of capacitors based on the flash ADC signal; and after the plurality of capacitors is pre-charged, the controller is configured to provide for sampling of the input voltage onto the plurality of capacitors, and the provision of an ADC output signal comprising a digital representation of the input voltage by the ADC.

## Description

### Field

The present disclosure relates to an analogue to digital converter, ADC. In particular to an energy efficient system comprising a flash ADC and an ADC.

### Summary

According to a first aspect of the present disclosure there is provided a system comprising: a voltage input terminal configured to receive an input voltage; flash analogue to digital converter, ADC; an ADC, wherein the ADC comprises: a plurality of capacitors configured and arranged such that they at least partially define the bit resolution of the ADC; a controller; wherein: the flash ADC is configured to receive the input voltage and provide a flash ADC signal, wherein the flash ADC signal is a digital representation of the input voltage; the controller is configured to provide for pre-charging of the plurality of capacitors based on the flash ADC signal; and after the plurality of capacitors is pre-charged, the controller is configured to provide for sampling of the input voltage onto the plurality of capacitors, and the provision of an ADC output signal comprising a digital representation of the input voltage by the ADC.

In one or more embodiments, the controller is configured to pre-charge at least a subset of the plurality of capacitors by connecting each capacitor to either a reference voltage or a ground voltage based on the flash ADC signal.

In one or more embodiments, each capacitor has a capacitance which is defined such that each capacitor is representative of a singular binary bit, such that the plurality of capacitors defines the bit resolution of the ADC.

In one or more embodiments, the controller is configured to sample the input voltage onto the plurality of capacitors by connecting each capacitor to the voltage input terminal.

In one or more embodiments, before providing for the pre-charging of the plurality of capacitors, the controller is configured to provide for the setting of the voltage across each capacitor of the plurality of capacitors to a predetermined voltage.

In one or more embodiments, the predetermined voltage is a common mode voltage minus either the reference voltage or the ground voltage.

In one or more embodiments, the ADC is a successive approximation register, SAR, ADC, and the plurality of capacitors is configured to define the bit resolution of the ADC.

In one or more embodiments, each capacitor of the plurality of capacitors comprises a top plate and a bottom plate.

In one or more embodiments, the top plate of each capacitor of the plurality of capacitors is connected to the top plate of each other capacitor of the plurality of capacitors.

In one or more embodiments, the top plates of each of the capacitors of the plurality of capacitors are selectably connectable, by the controller, to a common mode voltage terminal. The common mode voltage terminal may be configured to receive a common mode voltage.

In one or more embodiments, the bottom plate of each capacitor is selectably connectable, by the controller, to the voltage input terminal, a reference voltage terminal configured to receive a reference voltage, and a ground terminal configured to receive a ground voltage.

In one or more embodiments, the input voltage is a differential input voltage.

In one or more embodiments, the plurality of capacitors is a first plurality of capacitors.

In one or more embodiments, the voltage input terminal is a first voltage input terminal which is configured to receive a first input voltage.

In one or more embodiments, the system further comprises a second plurality of capacitors, which are also configured such that they define the bit resolution of the ADC.

In one or more embodiments, each capacitor of the second plurality of capacitors comprises a top plate and a bottom plate.

In one or more embodiments, the top plate of each capacitor of the second plurality of capacitors is connected to the top plate of each other capacitor of the second plurality of capacitors.

In one or more embodiments, the top plate of each capacitor of the second plurality of capacitors is selectably connectable, by the controller, to a common mode voltage terminal. The common mode voltage terminal may be configured to receive a common mode voltage.

In one or more embodiments, the bottom plate of each capacitor of the second plurality of capacitors is selectably connectable, by the controller, to: a second voltage input terminal which is configured to receive a second input voltage, a reference voltage terminal configured to receive a reference voltage, and a ground terminal configured to receive a ground voltage.

In one or more embodiments, the second input voltage has an equal magnitude and an opposite polarity to the first input voltage.

In one or more embodiments, the system further comprises a comparator.

In one or more embodiments, to provide the ADC output signal, the controller is configured to, after sampling the input voltage onto the capacitors: a) control the connections of the top and bottom plates of each capacitor of the first and second pluralities of capacitors, such that: the top plates of the first and second pluralities of capacitors are disconnected from the common mode voltage terminal; the bottom plate of a testing capacitor from each of the first and second pluralities of capacitors is connected to the reference voltage terminal, wherein: the testing capacitors each represent the most significant bit of the bit resolution of the ADC for which a value of the bit has not yet been determined; and the bottom plates of each capacitor of the first and second pluralities of capacitors which represents a less significant bit than the testing capacitors are connected to the ground terminal.

In one or more embodiments, if the testing capacitors do not represent the most significant bit of the bit resolution of the ADC, then: the bottom plates of any capacitors of the first and second pluralities of capacitors which represent a more significant bit than the testing capacitors are connected to either the reference voltage terminal or the ground terminal based on a prior determination of the bit represented by said capacitors.

In one or more embodiments, to provide the ADC output signal, the controller is configured to, after sampling the input voltage onto the capacitors b) compare, using the comparator, a voltage at the top plates of the first plurality of capacitors to a voltage at the top plates of the second plurality of capacitors.

In one or more embodiments, to provide the ADC output signal, the controller is configured to, after sampling the input voltage onto the capacitors, c) determine a value of the bit represented by the testing capacitors based on the comparison.

In one or more embodiments, to provide the ADC output signal, the controller is configured to, after sampling the input voltage onto the capacitors d) repeat steps (a) to (c) for each capacitor of the first and second pluralities of capacitors, such that a value of each bit of the bit resolution of the ADC is determined.

In one or more embodiments, each capacitor of the plurality of capacitors comprises a top plate and a bottom plate.

In one or more embodiments, the input voltage is a differential input voltage.

In one or more embodiments, the top plate of each capacitor of the plurality of capacitors is connected to the top plate of each other capacitor of the plurality of capacitors.

In one or more embodiments, the top plates of each of the capacitors of the plurality of capacitors are selectably connectable, by the controller to: a first voltage input terminal configured to receive a first input voltage, a reference voltage terminal configured to receive a reference voltage, and a ground terminal configured to receive a ground voltage.

In one or more embodiments, the bottom plate of each capacitor of the plurality of capacitors is selectably connectable, by the controller, to: a second voltage input terminal configured to receive a second input voltage, the reference voltage terminal, and the ground terminal.

In one or more embodiments, the second input voltage has an equal magnitude and an opposite polarity to the first input voltage.

In one or more embodiments, the plurality of capacitors is a first plurality of capacitors.

In one or more embodiments, the system further comprises a second plurality of capacitors which are also configured such that they define the bit resolution of the ADC.

In one or more embodiments, each capacitor of the second plurality of capacitors comprises a top plate and a bottom plate.

In one or more embodiments, the top plate of each capacitor of the second plurality of capacitors is connected to the top plate of each other capacitor of the second plurality of capacitors.

In one or more embodiments, the top plates of each of the capacitors of the second plurality of capacitors are selectably connectable, by the controller, to: the second voltage input terminal, a reference voltage terminal configured to receive a reference voltage, and a ground terminal configured to receive a ground voltage.

In one or more embodiments, the bottom plate of each capacitor of the second plurality of capacitors is selectably connectable, by the controller, to: the first voltage input terminal, the reference voltage terminal, and the ground terminal.

In one or more embodiments, the system further comprises a comparator.

In one or more embodiments, to provide the ADC output signal, the controller is configured to, after sampling the voltage onto the capacitors: a) control the connections of the top and bottom plates of each capacitor of the first and second pluralities of capacitors, such that: the top plates of the first and second pluralities of capacitors are disconnected from the respective first and second voltage terminals; the bottom plate of a testing capacitor from each of the first and second pluralities of capacitors is connected to the reference voltage terminal, wherein: the testing capacitors each represent the most significant bit of the bit resolution of the ADC for which a value of the bit has not yet been determined; and the bottom plates of each capacitor of the first and second pluralities of capacitors which represents a less significant bit than the testing capacitor are connected to the ground terminal.

In one or more embodiments, if the testing capacitors do not represent the most significant bit of the bit resolution of the ADC, then: the bottom plates of any capacitors of the first and second pluralities of capacitors which represent a more significant bit than the testing capacitors are connected to either the reference voltage terminal or the ground terminal based on a prior determination of the bit represented by said capacitors.

In one or more embodiments, to provide the ADC output signal, the controller is configured to, after sampling the voltage onto the capacitors: b) compare, using the comparator a voltage at the top plates of the capacitors of the first plurality of capacitors to a voltage at the top plates of the capacitors of the second plurality of capacitors.

In one or more embodiments, to provide the ADC output signal, the controller is configured to, after sampling the voltage onto the capacitors: c) determine a value of the bit represented by the testing capacitors based on the comparison.

In one or more embodiments, to provide the ADC output signal, the controller is configured to, after sampling the voltage onto the capacitors: d) repeat steps (a) to (c) for each capacitor of the first and second pluralities of capacitors, such that a value of each bit of the bit resolution of the ADC is determined.

In one or more embodiments, the flash ADC signal is a first flash ADC signal.

In one or more embodiments, after the first and second pluralities of capacitors are pre-charged, the flash ADC is configured to, either: receive the input voltage and provide a second flash ADC signal, or receive a top plate voltage of each of the first and second pluralities of capacitors.

In one or more embodiments, the controller is configured to determine a value for one or more of the most significant bits of the bit resolution of the ADC based on the second flash ADC signal.

According to a further aspect of the present disclosure there is provided a method for operating a system comprising: a flash ADC; and an ADC, wherein the ADC comprises a plurality of capacitors configured and arranged such that they at least partially define the bit resolution of the ADC; wherein the method comprises: receiving, via the flash ADC, an input voltage; providing, via a flash ADC, a flash ADC signal, wherein the flash ADC signal is a digital representation of the input voltage; providing for pre-charging of the plurality of capacitors based on the flash ADC signal; providing for sampling of the input voltage onto the plurality of capacitors; and providing, via the ADC, an ADC output signal comprising a digital representation of the input voltage.

While the disclosure is amenable to various modifications and alternative forms, specifics thereof have been shown by way of example in the drawings and will be described in detail. It should be understood, however, that other embodiments, beyond the particular embodiments described, are possible as well. All modifications, equivalents, and alternative embodiments falling within the spirit and scope of the appended claims are covered as well.

The above discussion is not intended to represent every example embodiment or every implementation within the scope of the current or future Claim sets. The figures and Detailed Description that follow also exemplify various example embodiments. Various example embodiments may be more completely understood in consideration of the following Detailed Description in connection with the accompanying Drawings.

### Brief Description of the Drawings

One or more embodiments will now be described by way of example only with reference to the accompanying drawings in which:
Figure 1 shows a system according to an embodiment of the present disclosure;
Figures 2A to 2E show an example system as it is used according to an embodiment of the present disclosure;
Figures 3A to 3E show another example system as it is used according to an embodiment of the present disclosure;

### Detailed Description

Analogue to digital converters (ADCs) are used in a wide variety of applications such as radio receivers, where there is an increased demand for power efficient high bandwidth high-resolution ADCs.

Many ADCs use capacitors to sample an input voltage, which may then be used for the provision of an ADC output signal which is digital representation of the input voltage. Capacitors take time and current to charge. Accordingly, when an input voltage is applied to the ADC for sampling and is therefore initially coupled to the capacitors there may be a large voltage difference between the input voltage and an existing voltage of the capacitors, thereby requiring a large current to charge the capacitors. This problem is exacerbated when large capacitors are used, which is common in the field of high-resolution ADCs due to kT/C noise requirements and matching when incorporating a capacitive digital analogue converter (CDAC).

A typical solution to the above problem exists in the form of a buffer which may supply the requisite current to the ADC for sampling. However, this buffer is often very power-hungry, and in many cases requires significantly more power than the ADC itself.

Embodiments of the present disclosure provide a system with a low peak current requirement for the sampling of the input voltage onto the capacitors. For the purposes of clarity and conciseness, the disclosure is described in the context of a successive approximation register (SAR) ADC, but it will be understood that the disclosed techniques may provide a technical advantage for any sampling-based ADCs, such as discrete-time pipelined ADCs and other SAR-assisted hybrid ADC architectures, for example, a two-stage SAR ADC.

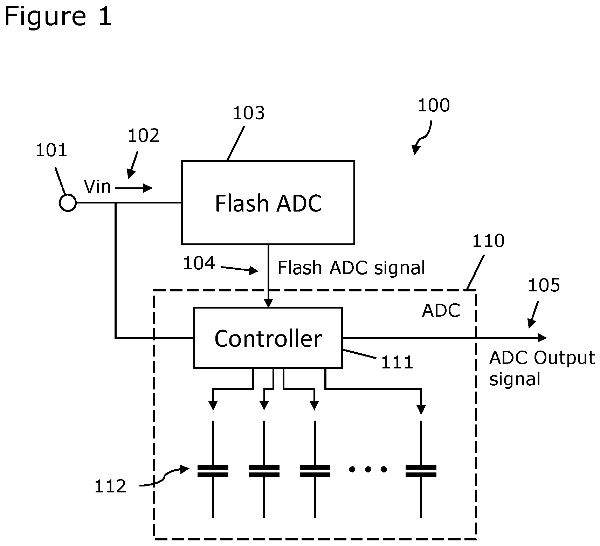

Figure 1 shows a system 100 according to an embodiment of the present disclosure. The system 100 includes a voltage input terminal 101 configured to receive an input voltage 102, a flash ADC 103 and an ADC 110.

A flash ADC 103 is an ADC which uses a linear voltage ladder (resistive or capacitive) with comparators at each 'rung' of the ladder to compare the input voltages to successive reference voltages. In this way, a flash ADC 103 may provide an approximate digital representation of an analogue signal quickly but with a relatively low resolution (when compared to many other types of ADC). Accordingly, in the present embodiments, the flash ADC 103 is configured to provide a lower resolution or lower accuracy digital representation of the input voltage 102 and the ADC 110 is configured to provide a higher resolution or higher accuracy digital representation of the input voltage 102.

The system 100 and/or ADC 110 includes a controller 111. The ADC 110 includes a plurality of capacitors 112, which are configured and arranged such that they at least partially define the bit resolution of the ADC 110. That is, if the ADC is a SAR ADC, then the plurality of capacitors is configured to define the bit resolution of the ADC, and if the ADC is not a SAR ADC, then the plurality of capacitors is configured to at least partially define the bit resolution of the ADC. Those skilled in the art will appreciate that the arrangement and sizing of the capacitors may vary between implementations of ADC and between different implementations of SAR ADCs.

For example, the plurality of capacitors 112 may include capacitors with different capacitances used in the determination of the bits of the digital representation of the input voltage. For example, each capacitor may represent a different bit of a digital signal (such as an array of capacitors with capacitances of C, 2C, 4C, 8C ..., for example). For the purposes of clarity and conciseness, the above example capacitor arrangement is described throughout the disclosure, and each capacitor is referred to as a unitary component. However, as understood by those skilled in the art, any other suitable arrangements may be used, and each capacitor (as referred to herein) may instead comprise an array of smaller capacitors which together provide a capacitance which is equivalent to a singular larger capacitor.

The flash ADC 103 receives the input voltage 102 and provides a flash ADC signal 104, which is a digital representation of the input voltage 102. Based on the flash ADC signal 104, the controller 111 provides for pre-charging of the plurality of capacitors 112 based on the flash ADC signal 104. That is, the controller 111 provides for at least one, a plurality forming a subset of the plurality of capacitors, or all of the plurality of capacitors 112 to be charged to a voltage which is defined by the flash ADC signal 104. The controller 111 may provide for the pre-charging of the plurality of capacitors 112 in any suitable way, such as by connecting each capacitor to either a reference voltage or a ground voltage based on the flash ADC signal, for example. The pre-charging may be provided for a predetermined pre-charge time or until a particular voltage level on the capacitor is reached.

After pre-charging the plurality of capacitors 112, the controller 111 provides for sampling of the input voltage 102 onto the pre-charged plurality of capacitors 112, and the provision of an ADC output signal 105 by the ADC 110. Thus, the charge on the capacitors will be based on the combination of the pre-charging and the subsequent sampling. The ADC output signal 105 is the output signal of the system 100.

The sampling of the input voltage 102 onto the plurality of capacitors may include connecting each capacitor to the voltage input terminal 101, and the provision of the ADC output signal 105 may be based on the sampling of the input voltage 102 onto the plurality of capacitors, for example. The provision of the ADC output signal 105 may be based on execution of a standard charge redistribution algorithm following the pre-charging.

Advantageously, by pre-charging the plurality of capacitors 112 based on the flash ADC signal 104 (i.e., to a voltage which approximately matches the input voltage 102), the difference between the input voltage 102 and the voltage stored (due to the pre-charge) on the plurality of capacitors is reduced, thereby reducing the peak current drawn during sampling. This may improve the power efficiency of the buffer, and reduce the time for generating the ADC output signal 105.

Further, before providing for the pre-charging of the plurality of capacitors, the controller may be configured to provide for the (re)setting the voltage across each capacitor of the plurality of capacitors to a predetermined voltage, such as 0V. In this way, the predetermined voltage may be defined in such a way that the plurality of capacitors may afterwards be switched during pre-charging in all cases (without being limited by switch position constraints, if switches are used) to obtain the voltage which is represented by the flash ADC signal 104.

It is beneficial to use a faster settling flash 103 ADC and to provide for a fast pre-charging operation, as the input voltage 102 may change between the flash ADC conversion and the sampling operation. As would be apparent to the skilled person, the precise speed of the pre-charging operation is dependent on the maximum frequency of the input signal. For example, when using a 4-bit flash ADC, it would be undesirable for the input to change more than 1/16th of full scale between activating the flash and sampling the input. Therefore, if the maximum input frequency was 10 MHz, then the upper limit of time for providing the flash ADC conversion and precharding the capacitors would be around 2ns.

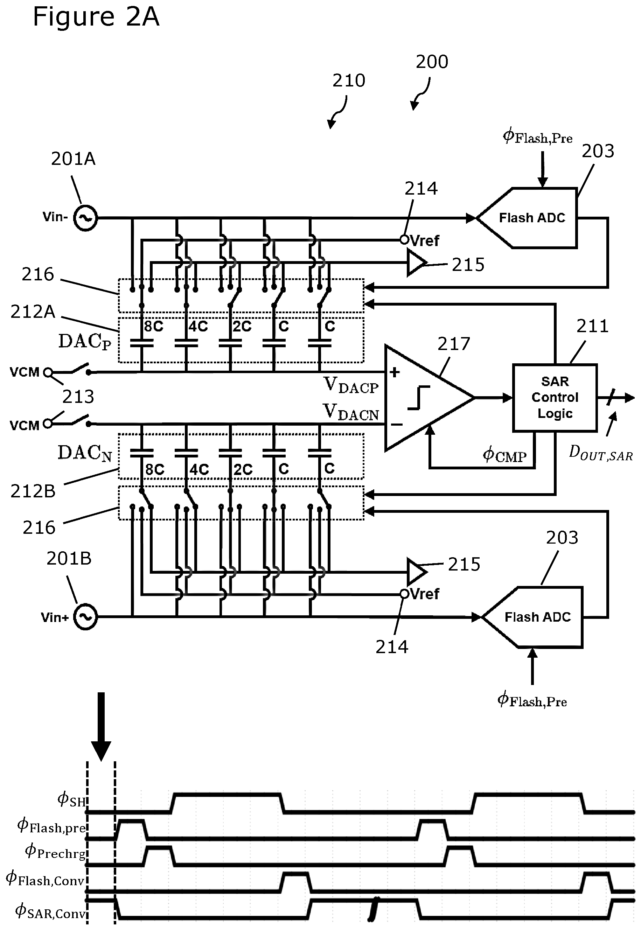

Figures 2A to 2E show an example system 200 as it is used according to an embodiment of the present disclosure. As described above, the system 200 includes a voltage input terminal 201A, 201B a flash ADC 203, and an ADC 210 which includes a plurality of capacitors 212 and a controller 211. The example system 200 also includes a comparator 217. Here, the ADC 210 is a SAR ADC, but as mentioned above, other ADC types may be used.

In the embodiment of Figures 2A-2E, the input voltage is a differential input voltage and therefore the voltage input terminal 201 is provided by a first voltage input terminal 201A to receive a first component of the differential voltage input signal and a second voltage input terminal 201B to receive a second component of the differential voltage input signal. Likewise, the plurality of capacitors 212 is arranged as a first plurality of capacitors 212A which are selectively and respectively coupled with the first voltage input terminal 201A and a second plurality of capacitors 212B which are selectively coupled with the second voltage input terminal 201B.

In this embodiment, each capacitor of the first plurality of capacitors 212A includes a top plate and a bottom plate. The top plate of each capacitor of the plurality of capacitors 212A may be connected to the top plate of each other capacitor of the first plurality of capacitors 212A. The top plate of each capacitor of the first plurality of capacitors may also be selectably connectable, by the controller 211, to a common mode voltage terminal 213, wherein the common mode voltage terminal is configured to receive a common mode voltage VCM. The top plates are also electrically coupled with a first terminal of the comparator 217.

The bottom plate of each capacitor of the first plurality of capacitors 212A may be selectably connectable, by the controller 211, to the first voltage input terminal 201A, a reference voltage terminal 214 configured to receive a reference voltage, and a ground terminal 215 configured to receive a ground voltage.

Each of the above-described selectable connections may be provided for using a plurality of switches 216, for example.

The second plurality of capacitors 212B are also configured such that they define the bit resolution of the ADC. Here, the second plurality of capacitors 212B define the bit resolution of the ADC in the same way as the first plurality of capacitors 212A (that is, by representing each bit with an appropriately sized capacitor).

In fact, the second plurality of capacitors 212B match the first plurality of capacitors 212A such that each capacitor of the second plurality of capacitors 212B is sized such that it is equivalent to one of the first plurality of capacitors 212A.

Similar to the first plurality of capacitors 212A, the top plate of each capacitor of the second plurality of capacitors 212B may be connected to the top plate of each other capacitor of the second plurality of capacitors 212B, and the top plate of each capacitor of the second plurality of capacitors 212B may also be selectably connectable, by the controller 211, to a common mode voltage terminal 213. The bottom plate of each capacitor of the second plurality of capacitors 212B may be selectably connectable, by the controller 211, to a second voltage input terminal 201B, a reference voltage terminal 214, and a ground terminal 215.

The second input voltage (as received by the second input voltage terminal 201B) may have an equal magnitude and an opposite polarity to the first input voltage (as received by the first input voltage terminal 201A), and the common mode voltage terminal 213, reference terminal 214, and ground terminal 215 which are selectably connectable to the second plurality of capacitors 212B may be the same or different to those terminals which are connected to the first plurality of capacitors 212A.

In this example, the reference voltage is 800mV, the ground voltage is 0V and the common mode voltage is 400mV, but other values may be used. Furthermore, two separate flash ADCs 203 are depicted in the drawings, but a single differential flash ADC may also be used. In examples which do not use a differential input voltage, a single flash ADC may be used.

During a first period, pictured in Figure 2A, the ADC 210 has just finished performing a previous conversion, and the plurality of switches 216 remain in arbitrary positions based on the previous conversion. Due to the nature of the SAR process, the first and second input voltages tend to approach each other, and when using the most commonly used switching schemes their common-mode stays equal to the common mode voltage.

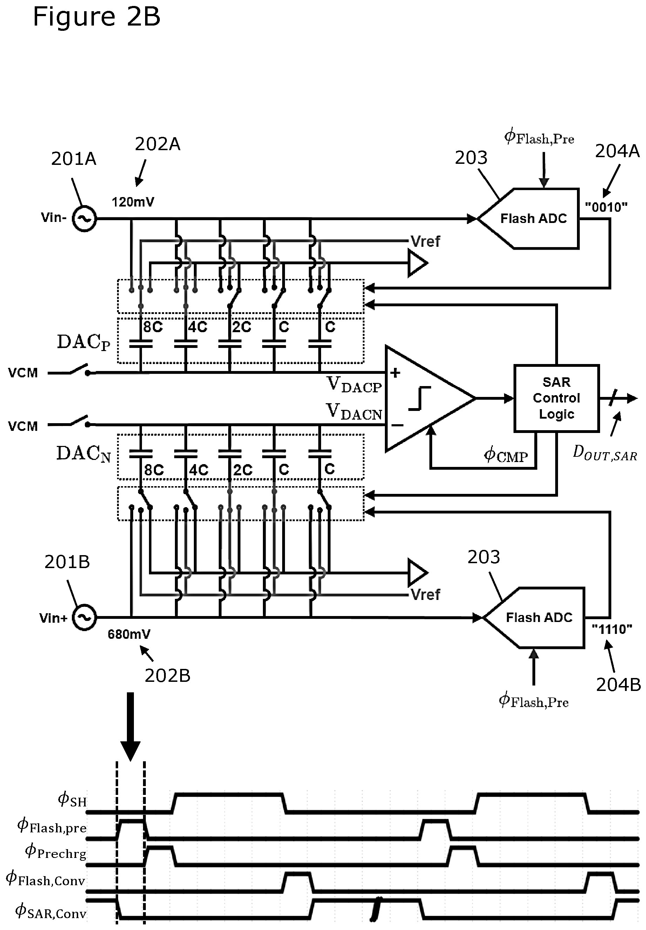

During a second period, pictured in Figure 2B, the flash ADC 203 (which in this example is a four-bit flash ADC 203, but other resolutions may be used) receives the first and second input voltages 202A, 202B from the first and second input voltage terminals 201A, 201B and provides a first and second flash ADC signal 204A, 204B. In this example, the first input voltage 202A is 120mV which results in a first flash ADC signal 204A of "0010" (which represents 100mV), and the second input voltage is 680mV which results in a second flash ADC signal 204B of "1110" (which represents 700mV). It will be appreciated that these outputs are examples and are not limiting.

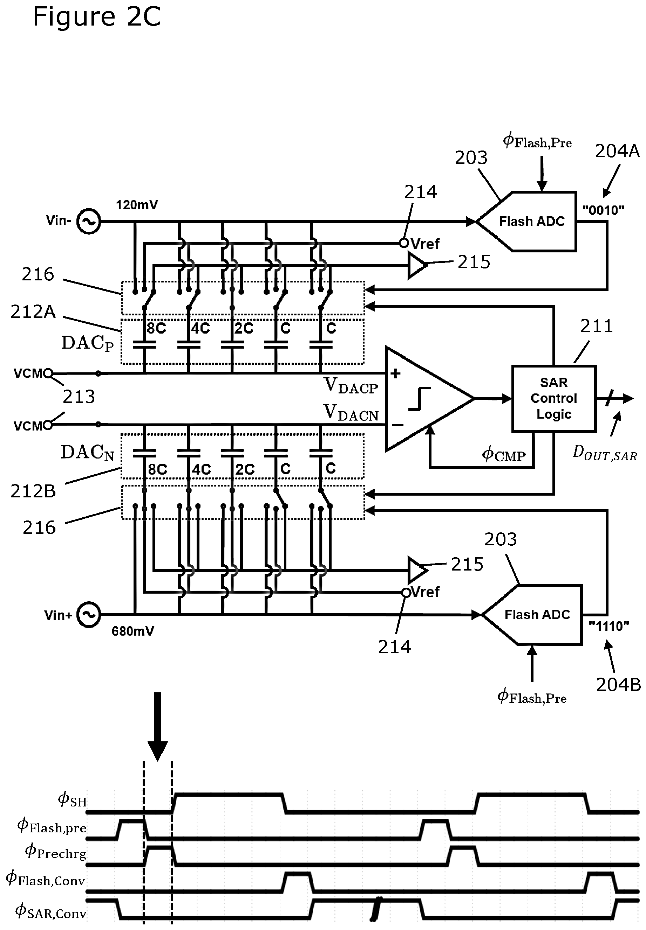

During a third period, pictured in Figure 2C, the plurality of switches 216 are set by the controller 211 such that the bottom plate of each capacitor of the first and second pluralities of capacitors 212A, 212B are connected to either the reference terminal 214 or the ground terminal 215 based on the respective first or second flash ADC signal 204A, 204B. In particular, the bottom plate of the capacitor which is representative of, or used in the determination of, a particular bit is connected to the reference terminal 214 if the respective bit of the respective flash ADC signal 204A, 204B is "1", and the capacitor is connected to the ground terminal 215 if the respective bit is "0", although of course, this could be reversed in some implementations. Furthermore, the top plates of each of the pluralities of capacitors 212A, 212B are connected to the common mode voltage terminal 213.

During the third period, the capacitors remain connected to either the reference terminal 214 or the ground terminal 215 for a predetermined time or until a voltage across each of the capacitors is at or close to the common mode voltage minus either the reference voltage or ground voltage respectively. For the purposes of providing an example and with an appreciation that those skilled in the art may provide a different configuration, the voltage across each of the capacitors may be considered close to the common mode voltage minus the reference or ground voltage if the average voltage across the capacitors differs by less than a voltage which, if received by the flash ADC 203 as the input voltage, would cause the flash ADC 203 to generate a flash ADC signal with a few least-significant-bits (such as 1, 2 or 3 least-significant bits, for example) set to "1", and all other bits set to "0".

In this way, at the end of the third period, the average bottom plate voltage of the first plurality of capacitors 212A is 100mV, the average bottom plate voltage of the second plurality of capacitors 212B is 700mV, and the top plate voltage of each of the capacitors is the 400mV (the common mode voltage).

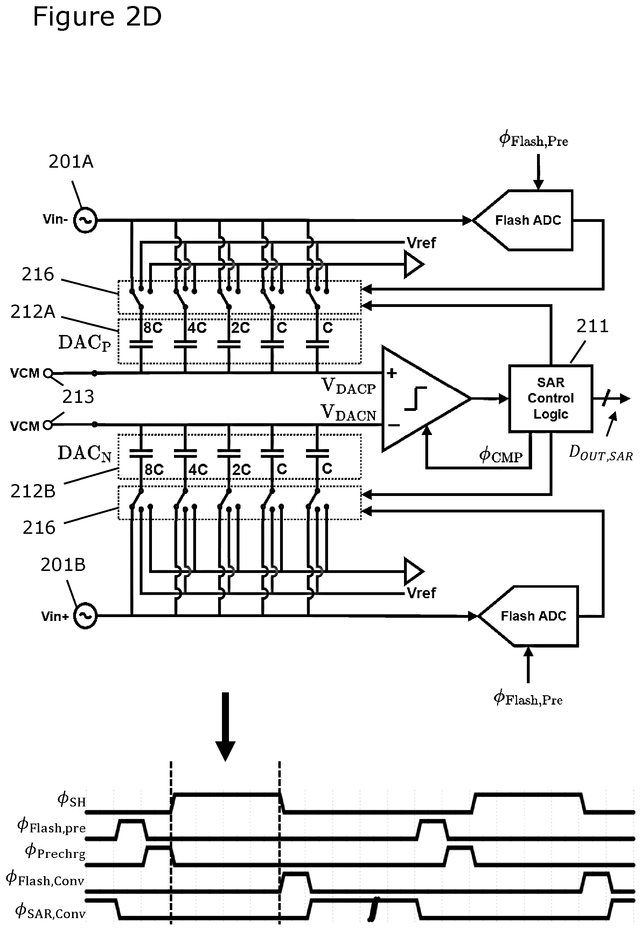

During a fourth period, pictured in Figure 2D, the ADC performs its sampling of the input voltage and thereby initiates its iterative determination of the digital representation of the input voltage. The plurality of switches 216 are set by the controller 211 such that the bottom plates of each of the capacitors of both the first and second pluralities of capacitors 212A, 212B are connected to either the first input voltage terminal 201A or the second input voltage terminal 201B, and the top plates remain connected to the common mode voltage terminal 213.

Advantageously, as the voltages of each of the capacitors were pre-charged to approximately reflect the respective input voltages, the peak current required to sample the input voltages is reduced when compared to a conventional ADC.

As above, the capacitors remain connected to the first and second input voltage terminals 201A, 201B and the common mode voltage terminal 213 for a stipulated sampling time that is chosen for a certain linearity.

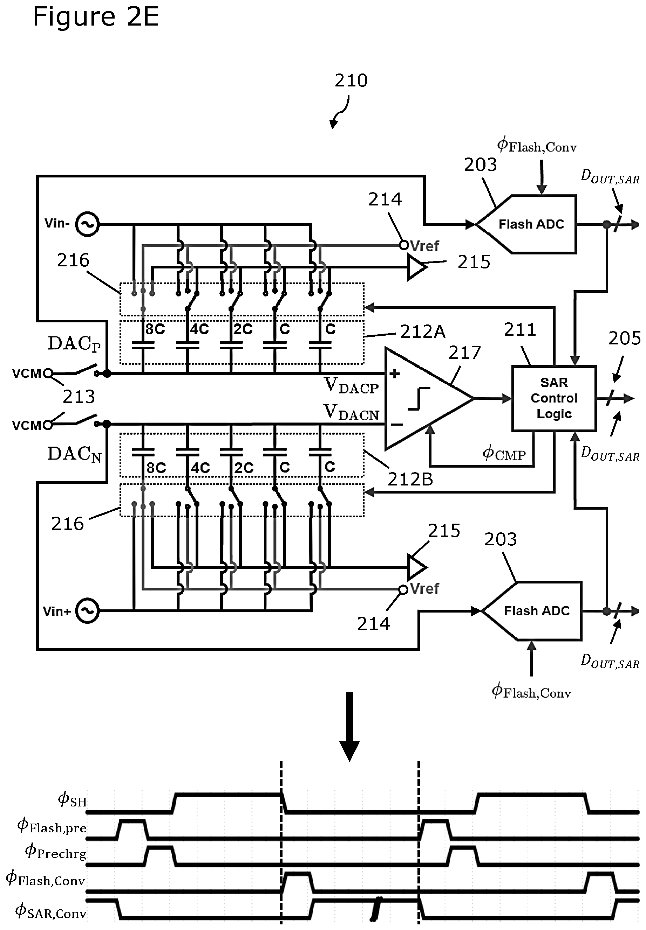

During a fifth period, pictured in Figure 2E, a typical SAR operation may be completed (by the controller 211) to provide the ADC output signal 205.

To provide the ADC output signal 205, the controller 211 may, after sampling the first and second input voltages onto the capacitors, perform steps (a) to (d) as described below.

First, the controller 211 (a) controls the top and bottom plates of each capacitor of the pluralities of capacitors 212A, 212B as follows:
- the top plates of each capacitor are disconnected from the common mode voltage terminal 213;
- the bottom plate of a testing capacitor from each of the first and second pluralities of capacitors 212A, 212B is connected to the reference voltage terminal 214, wherein the testing capacitors each represent the most significant bit of the bit resolution of the ADC for which a value of the bit has not yet been determined (in Figure 2E, the testing capacitors are those which are represented by 8C);
- If the testing capacitors do not represent the most significant bit of the bit resolution of the ADC 210 (which they do in this case), then the bottom plates of any capacitors of which represent a more significant bit than the testing capacitors are connected to either the reference voltage terminal 214 or the ground terminal 215 based on a prior determination of the bit represented by said capacitors; and
- the bottom plates of each capacitor which represents a less significant bit than the testing capacitors are connected to the ground terminal 215 (so, each of the capacitors represented by 4C, 2C, and C in the drawing).

After connecting the top and bottom plates of each capacitor of the pluralities of capacitors 212A, 212B as described above, the controller 211: (b) compares, using the comparator 217, a voltage at the top plates of the first plurality of capacitors 212A to a voltage at the top plates of the second plurality of capacitors 212B, and (c) determines a value of the bit represented by the testing capacitors (8C) based on the comparison.

After completing steps (a) to (c), the controller 211 (d) repeats steps (a) to (c) for each capacitor of the first and second pluralities of capacitors 212A, 212B, such that a value of each bit of the bit resolution of the ADC is determined (by starting with the capacitor representative of the most significant bit, which in this case is represented by 8C, for example).

In doing so, a value of each bit of the bit resolution of the ADC is determined such that each capacitor of the first plurality of capacitors 212A is connected to one of the reference terminal 214 and the ground terminal 215 and each corresponding capacitor (i.e., the one which is representative of the same bit) of the second plurality of capacitors 212B is connected to the other of the reference terminal 214 and the ground terminal 215.

After the values for each bit have been determined, the controller provides the ADC output signal in accordance with the determined bits. At this time, the system 200 is in a state which resembles the first period (such as depicted in Figure 2A), and the process may now repeat.

Since the first and second input voltages were sampled on the bottom plates of the first and second pluralities of capacitors 212A, 212B respectively, there is no restriction in the initial switch position for the SAR operation, regardless of the switch positions during the pre-charging operation.

In some (non-pictured) embodiments, the input voltage is not a differential voltage, and the system comprises only a single plurality of capacitors. In this embodiment, the top plate of each capacitor is connected to the top plate of each other capacitor. The top plates of each of the capacitors may also be selectably connectable, by the controller, to a common mode voltage terminal (like the common mode voltage terminal of Figures 2A-2E). The bottom plate of each capacitor may also be selectably connectable, by the controller, to the voltage input terminal, a reference voltage terminal, and a ground terminal.

In this embodiment, the above procedure (as described in relation to Figures 2A-2E) may still be used, except that the top plate voltage is compared, using a comparator, to a comparison voltage during the SAR operation instead of a top plate voltage of a second plurality of capacitors.

In some embodiments, the flash ADC 203 may provide a third (and in some cases fourth) flash ADC signal (not shown) based on either the input voltage or a top plate voltage of each plurality of capacitors, after the first and second pluralities of capacitors are pre-charged, but prior to step (a). Preferably, if the input voltage is used, the flash ADC provides the second flash ADC signal based on the input voltage at a time near to the end of sampling (that is, shortly before the end of the fourth period, such as within a final quarter of the fourth period, for example), and if the top plate voltage is used, then the flash ADC provides the second flash ADC signal after sampling (that is, after a conclusion of the fourth period). In this way, the second flash ADC signal is an accurate representation of the sampled input voltage at a time of the SAR operation. Then, the controller 211 may use the third (and fourth, if applicable) flash ADC signal to determine a value for one or more of the most significant bits of the bit resolution of the ADC. Advantageously, this may allow the ADC 210 to more quickly and efficiently determine and provide the ADC output signal because the comparison and determination of the one or more most significant bits may be omitted, without sacrificing accuracy.

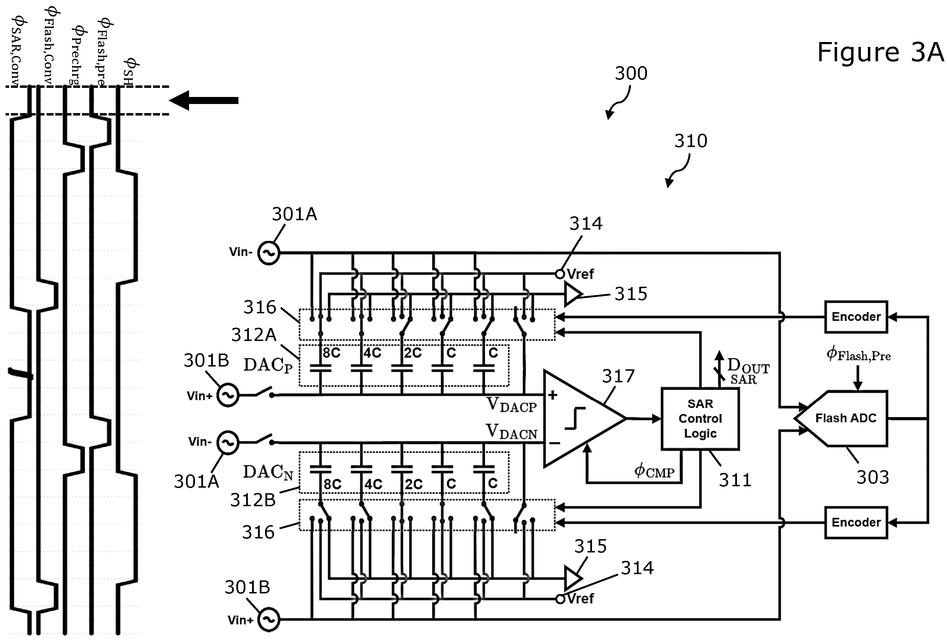

Figures 3A to 3E show another example system 300 as it is used according to an embodiment of the present disclosure. As described above, the system 300 includes a voltage input terminal 301A, a flash ADC 303, and an ADC 310 which includes a plurality of capacitors 312 and a controller 311. The example system 300 also includes a comparator 317. Here, the ADC 310 is a SAR ADC, but as mentioned above, other conversion techniques may be used. The Flash ADC 303 is a differential flash ADC.

In this example system 300, the input voltage is a differential input voltage and therefore the voltage input terminal 301 is provided by a first voltage input terminal 301A to receive a first component of the differential voltage input signal and a second voltage input terminal 301B to receive a second component of the differential voltage input signal. Likewise, the plurality of capacitors 312 is arranged as a first plurality of capacitors 312A and a second plurality of capacitors 312B.

In this embodiment, the system 300 is arranged similar to the system of Figures 2A-2E, except that, the top plates of each plurality of capacitors are selectably connectable to one of the first and second input voltage terminals 301A, 301B which receives an input voltage having an opposite polarity to the voltage received by the other of the first and second input voltage terminals 301A, 301B which is connectable to the bottom plates of said plurality of capacitors.

Furthermore, the connections of the first plurality of capacitors 312A to the first and second input terminals 301A, 301B are opposite to the connections of the second plurality of capacitors 312B to the first and second input terminals 301A, 301B. For example, in the pictured embodiment, the top plates of the first plurality of capacitors 312A are connectable to the first input voltage terminal 301A, the bottom plates of the first plurality of capacitors 312A are connectable to the second input voltage terminal 301B, the top plates of the second plurality of capacitors 312B are connectable to the second input terminal 301B, and the bottom plates of the second plurality of capacitors 312B are connectable to the first input terminal 301A. Of course, the reverse of the above is also possible. As a result of this structure, the ADC 310 provides an inherent 2x gain when compared to the example of Figures 2A-2E, and the maximum differential input voltage is halved.

Furthermore, the top plates of the capacitors are selectably connectable to the reference terminal 314 and the ground terminal 315 for providing a closed circuit during the pre-charging operation.

That is, the top plate of each capacitor of the first plurality of capacitors 312A is connected to the top plate of each other capacitor of the first plurality of capacitors 312A, and the top plates of each of the capacitors are also selectably connectable, by the controller 311, to a first voltage input terminal 301A configured to receive provide a first input voltage, a reference terminal 314 configured to receive provide a reference voltage, and a ground terminal 315 configured to receive provide a ground voltage.

The bottom plate of each capacitor of the first plurality of capacitors 312A is selectably connectable, by the controller 311, to a second voltage input terminal 301B configured to receive a second input voltage, the reference voltage terminal 314, and the ground terminal 315. As before, the second input voltage has an equal magnitude and an opposite polarity to the first input voltage.

As before, the second plurality of capacitors 312B are also configured such that they define the bit resolution of the ADC. In this example the second plurality of capacitors 312B define the bit resolution of the ADC in the same way as the first plurality of capacitors 212A (that is, by representing each bit with an appropriately sized capacitor).

Similar to the first plurality of capacitors 312A, the top plate of each capacitor of the second plurality of capacitors 312B is connected to the top plate of each other capacitor of the second plurality of capacitors 312B. The top plates of each of the capacitors of the second plurality of capacitors are also selectably connectable, by the controller 311, to the second voltage input terminal, a reference voltage terminal configured to receive a reference voltage, and a ground terminal configured to receive a ground voltage.

The bottom plate of each capacitor of the second plurality of capacitors 312B is selectably connectable, by the controller 311, to the first voltage input terminal, the reference voltage terminal, and the ground terminal.

As before, the reference terminal 314 and ground terminal 315 which are selectably connectable to the second plurality of capacitors 312B may be the same or different to those terminals which are connected to the first plurality of capacitors 312A.

In this example, the reference voltage is 800mV and the ground voltage is 0V, but other values may be used.

The first period, shown in Figure 3A, is the same as the first period of the previous example, wherein the plurality of switches 316 remain in arbitrary positions.

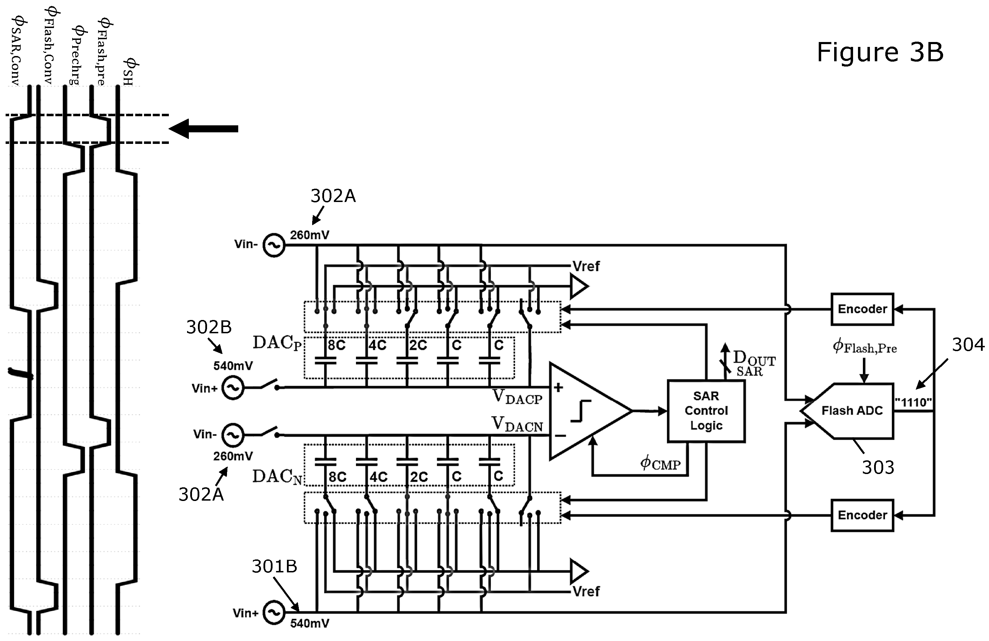

The second period, shown in Figure 3B, is also the same as the second period of the previous example, wherein the flash ADC 303 provides the flash ADC signal 304 based on the first and second input voltages 302A, 302B. In this example, the first input voltage 302A is 260mV and the second input voltage 302B is 540mV, which results in a flash ADC signal 304A of "1110" (which represents +300mV, wherein the first bit is a sign bit).

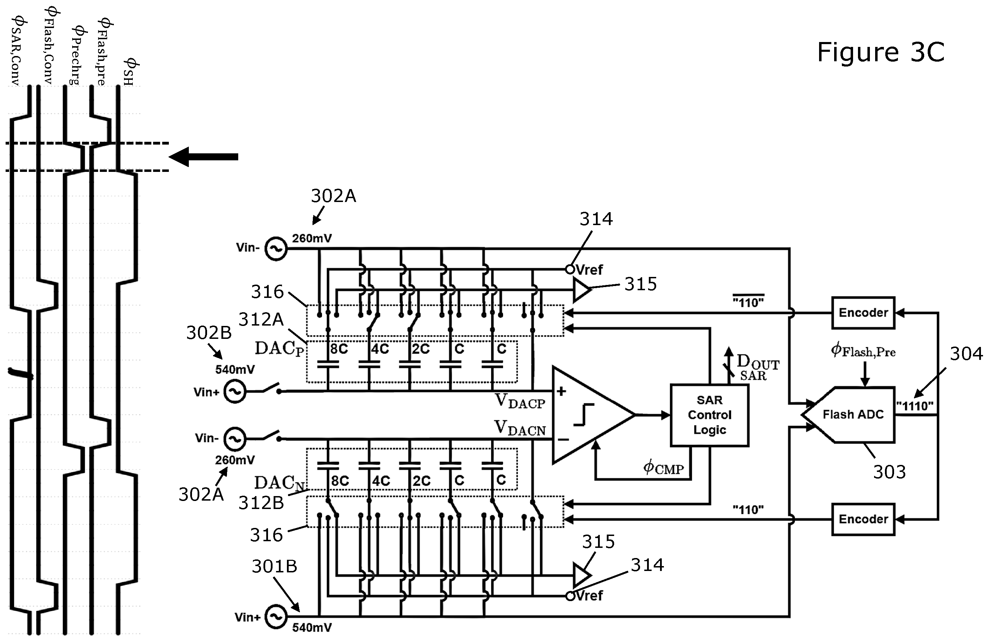

The third period, shown in Figure 3C, is similar to the third period of the previous example, wherein, the plurality of switches 316 are set by the controller 311 such that the bottom plates of each capacitor are connected to either the reference terminal 314 or the ground terminal 315 based on the flash ADC signal 304.

The bottom plate of the capacitor representative of, or used in the determination of, the most significant bit (which in this example is represented by 8C) of the first plurality of capacitors 312A is connected to either the reference terminal 314 or the ground terminal 315 based on the sign bit of the flash ADC signal 304, and the bottom plate of the corresponding capacitor of the second plurality of capacitors 312B is connected to the other of the reference terminal 314 and the ground terminal 315. In this example, the sign bit is 1, which represents a positive differential voltage, therefore the bottom plate of the most-significant-bit capacitor (8C) of the first plurality of capacitors 312A is connected to the reference terminal 314 and the bottom plate of the most-significant-bit capacitor (8C) of the second plurality of capacitors 312B is connected to the ground terminal 315.

The top plates of each plurality of capacitors 312A, 312B are also connected to either the reference terminal 314 or the ground terminal 315 based on the sign bit of the flash ADC signal 304 in the same way as for the most-significant-bit capacitors. That is, in this example, the top plates of the first plurality of capacitors 312A are connected to the reference terminal 314 and the top plates of the second plurality of capacitors 312B are connected to the ground terminal 315.

The connections of the bottom plates of the remaining (non-most-significant-bit) capacitors of the first plurality of capacitors 312A are controlled by an inverted flash ADC signal (minus the sign bit, so in this case, "001"), and the connections of the bottom plates of the remaining (non-most-significant-bit) second plurality of capacitors 312B are controlled by a non-inverted flash ADC signal 304 (so, "110"). The choice of which of the first and second pluralities of capacitors 312A, 312B are controlled by the flash ADC signal 304 and which are controlled by the inverted flash ADC signal is made based on the sign bit of the flash ADC signal 304 (which is "1" in this example).

As before, the bottom plate of the capacitor which is representative of, or used in the determination of, a particular bit is connected to the reference terminal 314 if the respective bit of the respective inverted or non-inverted flash ADC signal 304 is "1", and the capacitor is connected to the ground terminal 315 if the respective bit is "0", although of course, this could be reversed in some implementations.

Instead of a common mode terminal (which of course is not present in this embodiment), the top plates of each of the pluralities of capacitors 312A, 312B are connected to either the reference terminal 314 or the ground terminal 315 based on the sign bit (the first bit) of the received inverted or non-inverted flash ADC signal 304. In this example, if the flash ADC signal 304 represents a positive differential voltage (which is the case in the pictured example), the top plates of the first plurality of capacitors 312A are connected to the reference terminal 314 and the top plates of the second plurality of capacitors 312B are connected to the ground terminal 315. Conversely, if the flash ADC signal 304 represents a negative differential voltage (which is not the case in the pictured example), the top plates of the first plurality of capacitors 312A would be connected to the ground terminal 315 and the top plates of the second plurality of capacitors 312B would be connected to the reference terminal 314. Of course, in some other embodiments, this may be reversed.

In this way, the plurality of switches 316 connected to the first plurality of capacitors 312A are the exact inverse of the plurality of switches 316 which are connected to the second plurality of capacitors 312B.

As before, during the third period, the capacitors remain connected to either the reference terminal 314 or the ground terminal 315 for a predetermined time or until a voltage across each of the capacitors is at or close to the reference voltage or ground voltage respectively. For the purposes of this disclosure, the voltage across each of the capacitors may be considered close to the reference or ground voltage if the average voltage across the capacitors differs by less than a voltage which, if received by the flash ADC 303 as the input voltage, would cause the flash ADC 303 to generate a flash ADC signal with a few least-significant-bits (such as 1, 2 or 3 least-significant bits, for example) set to "1", and all other bits set to "0".

In this way, at the end of the third period, the average voltage of the first plurality of capacitors 312A is +300mV and the average voltage of the second plurality of capacitors 312B is -300mV (in this example).

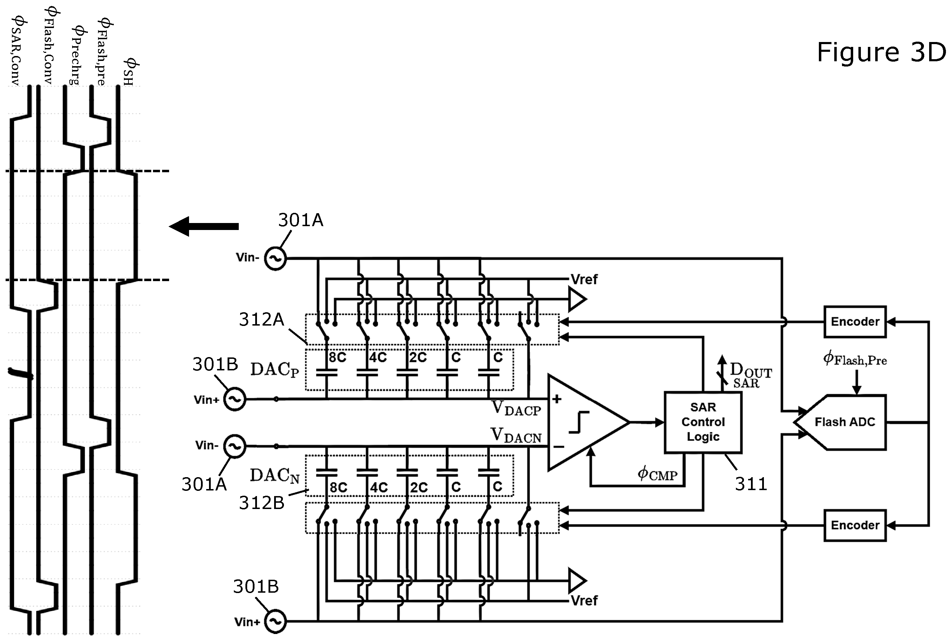

The fourth period, shown in Figure 3D, is the same as the fourth period of the previous example, and the ADC performs its sampling of the input voltage and thereby initiates its iterative determination of the digital representation of the input voltage. The first and second input voltages are sampled onto the first and second pluralities of capacitors 312A, 312B. However, each plurality of capacitors 312A, 312B is connected, by the controller 311, to both the first and second input terminals 301A, 301B, instead of to one of the first and second input terminals 301A, 301B and a common mode voltage terminal.

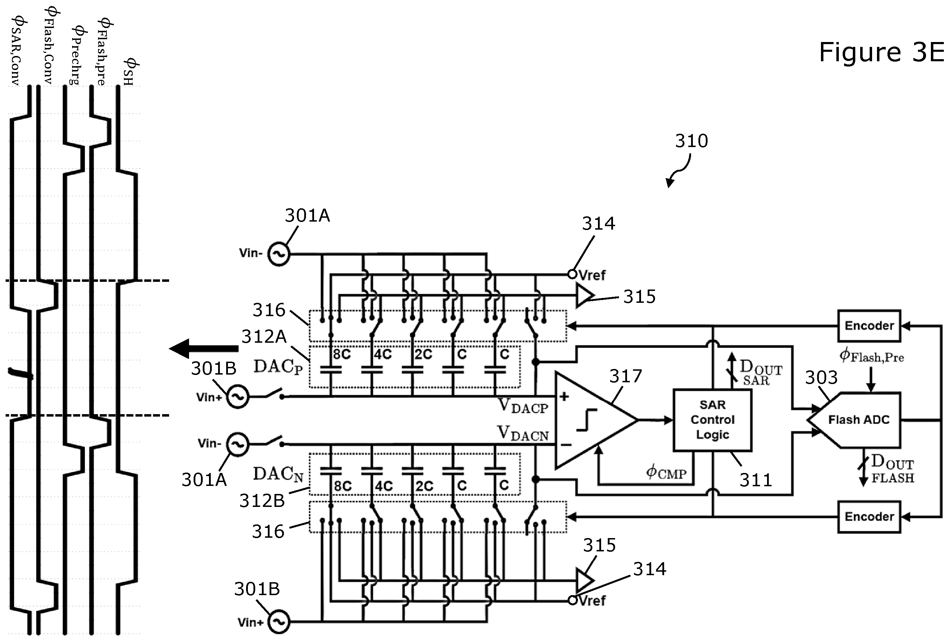

The fifth period, shown in Figure 3E, is the same as the fifth period of the previous example.

That is, after sampling the voltage onto the capacitors, the controller 311 performs steps (a) to (d) as described below.

First, the controller 311 a) controls connections to the top and bottom plates of each capacitor of the pluralities of capacitors 312A, 312B as follows:
- the top plates of each capacitor are disconnected from the respective first and second voltage terminals 301A, 301B;
- the bottom plate of a testing capacitor (defined in the same way as in the example of Figures 2A-2E, which is again shown to be the capacitor represented by 8C) from each of the first and second pluralities of capacitors 312A, 312B is connected to the reference voltage terminal 314;
- if the testing capacitors do not represent the most significant bit of the bit resolution of the ADC 310 (which they do in this case), then the bottom plates of any capacitors which represent a more significant bit than the testing capacitors are connected to either the reference voltage terminal 314 or the ground terminal 315 based on a prior determination of the bit represented by said capacitors; and
- the bottom plates of each capacitor which represents a less significant bit than the testing capacitor are connected to the ground terminal 315 (so, each of the capacitors represented by 4C, 2C, and C in the drawing).

After connecting the top and bottom plates of each capacitor of the pluralities of capacitors 312A, 312B as described above, the controller 311: (b) compares, using the comparator 317, a voltage at the top plates of the capacitors of the first plurality of capacitors 312A to a voltage at the top plates of the capacitors of the second plurality of capacitors 312B, and (c) determines a value of the bit represented by the testing capacitors (8C) based on the comparison.

After completing steps (a) to (c), the controller 311 (d) repeats steps (a) to (c) for each capacitor of the first and second pluralities of capacitors 312A, 312B, such that a value of each bit of the bit resolution of the ADC is determined (by starting with the capacitor representative of the most significant bit, which in this case is represented by 8C, for example).

In doing so, a value of each bit of the bit resolution of the ADC is determined such that each capacitor of the first plurality of capacitors 312A is connected to one of the reference terminal 314 and the ground terminal 315 and each corresponding capacitor (i.e., the one which is representative of the same bit) of the second plurality of capacitors 312B is connected to the other of the reference terminal 314 and the ground terminal 315.

In some (non-pictured) embodiments, the input voltage is not a differential voltage, and the system comprises only a single plurality of capacitors. In these embodiments, the top plate of each capacitor is connected to the top plate of each other capacitor, and may be selectably connectable, by the controller to a first voltage input terminal, a reference voltage terminal, and a ground terminal. The bottom plate of each capacitor may also be selectably connectable, by the controller, to a second voltage input terminal, the reference voltage terminal, and the ground terminal.

In these embodiments, the above procedure (as described in relation to Figures 3A-3E) may still be used, except that the top plate voltage is compared to a comparison voltage during the SAR operation instead of a top plate voltage of a second plurality of capacitors.

In some embodiments, the flash ADC 303 may provide a second flash ADC signal (not shown) based on either the input voltage or a top plate voltage of each plurality of capacitors, after the first and second pluralities of capacitors are pre-charged, but prior to step (a). Preferably, if the input voltage is used, the flash ADC provides the second flash ADC signal based on the input voltage at a time near to the end of sampling (that is, shortly before the end of the fourth period, such as within a final quarter of the fourth period, for example), and if the top plate voltage is used, then the flash ADC provides the second flash ADC signal after sampling (that is, after a conclusion of the fourth period). In this way, the second flash ADC signal is an accurate representation of the sampled input voltage at a time of the SAR operation. Then, the controller 311 may use the second flash ADC signal to determine a value for one or more of the most significant bits of the bit resolution of the ADC. Advantageously, this may allow the ADC 310 to more quickly and efficiently determine and provide the ADC output signal because the comparison and determination of the one or more most significant bits may be omitted, without sacrificing accuracy.

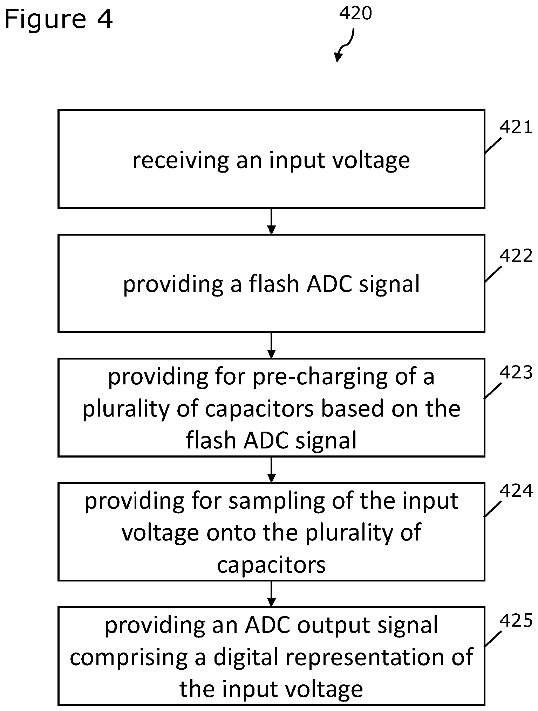

Figure 4 shows an example method 420 for operating a system comprising an ADC and a flash ADC according to an embodiment of the present disclosure.

The method 420 includes, at step 421, receiving, via the flash ADC, an input voltage, and providing, at step 422, via the flash ADC, a flash ADC signal, wherein the flash ADC signal is a digital representation of the input voltage.

Next, at step 423, the method 420 includes providing for pre-charging of the plurality of capacitors based on the flash ADC signal. At step 424, the method 420 includes providing for sampling of the input voltage onto the plurality of capacitors, and at step 425, the method 420 includes providing, via the ADC, an ADC output signal comprising a digital representation of the input voltage.

The instructions and/or flowchart steps in the above figures may be executed in any order, unless a specific order is explicitly stated. Also, those skilled in the art will recognize that while one example set of instructions/method has been discussed, the material in this specification may be combined in a variety of ways to yield other examples as well, and are to be understood within a context provided by this detailed description.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor may refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer usable storage medium or media is (are) considered to be part of an article (or article of manufacture). An article or article of manufacture may refer to any manufactured single component or multiple components. The non-transient machine or computer usable media or mediums as defined herein excludes signals, but such media or mediums may be capable of receiving and processing information from signals and/or other transient mediums.

Example embodiments of the material discussed in this specification may be implemented in whole or in part through network, computer, or data based devices and/or services. These may include cloud, internet, intranet, mobile, desktop, processor, look-up table, microcontroller, consumer equipment, infrastructure, or other enabling devices and services. As may be used herein and in the claims, the following non-exclusive definitions are provided.

In one example, one or more instructions or steps discussed herein are automated. The terms automated or automatically (and like variations thereof) mean controlled operation of an apparatus, system, and/or process using computers and/or mechanical/electrical devices without the necessity of human intervention, observation, effort and/or decision.

It will be appreciated that any components said to be coupled may be coupled or connected either directly or indirectly. In the case of indirect coupling, additional components may be located between the two components that are said to be coupled.

In this specification, example embodiments have been presented in terms of a selected set of details. However, a person of ordinary skill in the art would understand that many other example embodiments may be practiced which include a different selected set of these details. It is intended that the following claims cover all possible example embodiments.

## Claims

1. A system comprising:
a voltage input terminal configured to receive an input voltage;
a flash analogue to digital converter, ADC;
an ADC, wherein the ADC comprises:
a plurality of capacitors configured and arranged such that they at least partially define a bit resolution of the ADC;
a controller; wherein:
the flash ADC is configured to receive the input voltage and provide a flash ADC signal, wherein the flash ADC signal is a digital representation of the input voltage;
the controller is configured to provide for pre-charging of the plurality of capacitors based on the flash ADC signal; and
after the plurality of capacitors is pre-charged, the controller is configured to provide for sampling of the input voltage onto the plurality of capacitors, and the provision of an ADC output signal comprising a digital representation of the input voltage by the ADC.

2. The system of claim 1, wherein the controller is configured to pre-charge at least a subset of the plurality of capacitors by connecting each capacitor to either a reference voltage or a ground voltage based on the flash ADC signal.

3. The system of claim 1 or 2, wherein each capacitor has a capacitance which is defined such that each capacitor is representative of a singular binary bit, such that the plurality of capacitors defines the bit resolution of the ADC.

4. The system of any preceding claim, wherein the controller is configured to sample the input voltage onto the plurality of capacitors by connecting each capacitor to the voltage input terminal.

5. The system of any preceding claim, wherein, before providing for the pre-charging of the plurality of capacitors, the controller is configured to provide for the setting of the voltage across each capacitor of the plurality of capacitors to a predetermined voltage.

6. The system of claim 5, wherein the predetermined voltage is a common mode voltage minus either the reference voltage or the ground voltage.

7. The system of any preceding claim, wherein the ADC is a successive approximation register, SAR, ADC, and the plurality of capacitors is configured to define the bit resolution of the ADC.

8. The system of any preceding claim, wherein each capacitor of the plurality of capacitors comprises a top plate and a bottom plate, wherein:
the top plate of each capacitor of the plurality of capacitors is connected to the top plate of each other capacitor of the plurality of capacitors;
the top plates of each of the capacitors of the plurality of capacitors are selectably connectable, by the controller, to a common mode voltage terminal, wherein the common mode voltage terminal is configured to receive a common mode voltage; and
the bottom plate of each capacitor is selectably connectable, by the controller, to:
the voltage input terminal,
a reference voltage terminal configured to receive a reference voltage, and
a ground terminal configured to receive a ground voltage.

9. The system of claim 8, wherein:
the input voltage is a differential input voltage;
the plurality of capacitors is a first plurality of capacitors;
the voltage input terminal is a first voltage input terminal which is configured to receive a first input voltage;
the system further comprises a second plurality of capacitors, which are also configured such that they define the bit resolution of the ADC;
each capacitor of the second plurality of capacitors comprises a top plate and a bottom plate,
the top plate of each capacitor of the second plurality of capacitors is connected to the top plate of each other capacitor of the second plurality of capacitors;
the top plate of each capacitor of the second plurality of capacitors is selectably connectable, by the controller, to a common mode voltage terminal, wherein the common mode voltage terminal is configured to receive a common mode voltage; and
the bottom plate of each capacitor of the second plurality of capacitors is selectably connectable, by the controller, to:
a second voltage input terminal which is configured to receive a second input voltage,
a reference voltage terminal configured to receive a reference voltage, and
a ground terminal configured to receive a ground voltage; and
the second input voltage has an equal magnitude and an opposite polarity to the first input voltage.

10. The system of claim 8 or 9, further comprising a comparator, wherein, to provide the ADC output signal, the controller is configured to, after sampling the input voltage onto the capacitors:
a) control the connections of the top and bottom plates of each capacitor of the first and second pluralities of capacitors, such that:
the top plates of the first and second pluralities of capacitors are disconnected from the common mode voltage terminal;
the bottom plate of a testing capacitor from each of the first and second pluralities of capacitors is connected to the reference voltage terminal, wherein:
the testing capacitors each represent the most significant bit of the bit resolution of the ADC for which a value of the bit has not yet been determined;
if the testing capacitors do not represent the most significant bit of the bit resolution of the ADC, then:
the bottom plates of any capacitors of the first and second pluralities of capacitors which represent a more significant bit than the testing capacitors are connected to either the reference voltage terminal or the ground terminal based on a prior determination of the bit represented by said capacitors; and
the bottom plates of each capacitor of the first and second pluralities of capacitors which represents a less significant bit than the testing capacitors are connected to the ground terminal;
b) compare, using the comparator, a voltage at the top plates of the first plurality of capacitors to a voltage at the top plates of the second plurality of capacitors;
c) determine a value of the bit represented by the testing capacitors based on the comparison; and
d) repeat steps (a) to (c) for each capacitor of the first and second pluralities of capacitors, such that a value of each bit of the bit resolution of the ADC is determined.

11. The system of any of claims 1-7, wherein each capacitor of the plurality of capacitors comprises a top plate and a bottom plate, wherein:
the input voltage is a differential input voltage;
the top plate of each capacitor of the plurality of capacitors is connected to the top plate of each other capacitor of the plurality of capacitors;
the top plates of each of the capacitors of the plurality of capacitors are selectably connectable, by the controller to:
a first voltage input terminal configured to receive a first input voltage,
a reference voltage terminal configured to receive a reference voltage, and
a ground terminal configured to receive a ground voltage;
the bottom plate of each capacitor of the plurality of capacitors is selectably connectable, by the controller, to:
a second voltage input terminal configured to receive a second input voltage,
the reference voltage terminal, and
the ground terminal; and
the second input voltage has an equal magnitude and an opposite polarity to the first input voltage.

12. The system of claim 11, wherein:
the plurality of capacitors is a first plurality of capacitors;
the system further comprises a second plurality of capacitors which are also configured such that they define the bit resolution of the ADC;
each capacitor of the second plurality of capacitors comprises a top plate and a bottom plate,
the top plate of each capacitor of the second plurality of capacitors is connected to the top plate of each other capacitor of the second plurality of capacitors;
the top plates of each of the capacitors of the second plurality of capacitors are selectably connectable, by the controller, to:
the second voltage input terminal,
a reference voltage terminal configured to receive a reference voltage, and
a ground terminal configured to receive a ground voltage; and
the bottom plate of each capacitor of the second plurality of capacitors is selectably connectable, by the controller, to:
the first voltage input terminal,
the reference voltage terminal, and
the ground terminal.

13. The system of claim 11 or 12, further comprising a comparator, wherein, to provide the ADC output signal, the controller is configured to, after sampling the voltage onto the capacitors:
a) control the connections of the top and bottom plates of each capacitor of the first and second pluralities of capacitors, such that:
the top plates of the first and second pluralities of capacitors are disconnected from the respective first and second voltage terminals;
the bottom plate of a testing capacitor from each of the first and second pluralities of capacitors is connected to the reference voltage terminal, wherein:
the testing capacitors each represent the most significant bit of the bit resolution of the ADC for which a value of the bit has not yet been determined;
if the testing capacitors do not represent the most significant bit of the bit resolution of the ADC, then:
the bottom plates of any capacitors of the first and second pluralities of capacitors which represent a more significant bit than the testing capacitors are connected to either the reference voltage terminal or the ground terminal based on a prior determination of the bit represented by said capacitors; and
the bottom plates of each capacitor of the first and second pluralities of capacitors which represents a less significant bit than the testing capacitor are connected to the ground terminal;
b) compare, using the comparator a voltage at the top plates of the capacitors of the first plurality of capacitors to a voltage at the top plates of the capacitors of the second plurality of capacitors;
c) determine a value of the bit represented by the testing capacitors based on the comparison; and
d) repeat steps (a) to (c) for each capacitor of the first and second pluralities of capacitors, such that a value of each bit of the bit resolution of the ADC is determined.

14. The system of claim 9 or 13, wherein:
the flash ADC signal is a first flash ADC signal;
after the first and second pluralities of capacitors are pre-charged, but prior to step (a), the flash ADC is configured to, either:
receive the input voltage and provide a second flash ADC signal, or
receive a top plate voltage of each of the first and second pluralities of capacitors and provide a second flash ADC signal; and
the controller is configured to determine a value for one or more of the most significant bits of the bit resolution of the ADC based on the second flash ADC signal.

15. A method for operating a system comprising:
a flash ADC; and
an ADC, wherein the ADC comprises a plurality of capacitors configured and arranged such that they at least partially define the bit resolution of the ADC;
wherein the method comprises:
receiving, via the flash ADC, an input voltage;
providing, via a flash ADC, a flash ADC signal, wherein the flash ADC signal is a digital representation of the input voltage;
providing for pre-charging of the plurality of capacitors based on the flash ADC signal;
providing for sampling of the input voltage onto the plurality of capacitors; and
providing, via the ADC, an ADC output signal comprising a digital representation of the input voltage.
